# EUROPEAN PATENT SPECIFICATION

(11) **EP 4 523 502 B1**
(45) Date of publication and mention of the grant of the patent: **22.04.2026**
(21) Application number: 23724845.5
(22) Date of filing: 11.05.2023
(51) Int. Cl.: H05K 7/20

(54) **CIRCUIT BOARD ARRANGEMENT WITH CIRCUIT BOARDS PIVOTABLE FROM A MOUNTING POSITION INTO AN INTERMEDIATE POSITION**
LEITERPLATTENANORDNUNG MIT LEITERPLAATTEN, DIE VON EINER MONTAGEPOSITION IN EINE ZWISCHENPOSITION SCHWENKBAR SIND
AGENCEMENT DE CARTES DE CIRCUIT IMPRIMÉ À CARTES DE CIRCUIT IMPRIMÉ POUVANT PIVOTER D'UNE POSITION DE MONTAGE À UNE POSITION INTERMÉDIAIRE

(30) Priority: 13.05.2022 DE 102022112002
(43) Date of publication of application: 19.03.2025
(73) Proprietor: Connaught Electronics Ltd., Tuam, County Galway (IE)
(72) Inventor: CASAGRANDE, Ramon, Tuam (IE)
(74) Representative: Jauregui Urbahn, Kristian
(86) International application number: PCT/EP2023/062532
(87) International publication number: WO 2023/217925

(56) References cited:
- EP-B1- 0 316 129
- US-B1- 7 212 409

## Description

The invention relates to a circuit board arrangement with at least one housing, in which a plurality of circuit boards is arranged, and with at least one cooling device, through which a cooling fluid can be passed, and which is formed for dissipating heat from at least one of the circuit boards. The at least one of the circuit boards is thermally coupled to the at least one cooling device by means of at least one heat transfer element.

In particular if a plurality of powerful electronic control devices or electronic control units is present in a vehicle, it can be provided to arrange these control devices stacked above each other in a housing or rack. In the operation, heat is released by circuit boards of the control devices or electronic control units, which should be dissipated. For dissipating the heat, it can be provided to thermally couple the circuit boards to at least one cooling device, which is supplied with a cooling fluid in the cooling operation, via respective heat transfer elements.

For example, US 10 085 364 B2 describes an arrangement with a housing and circuit boards arranged above each other in the housing. The circuit boards are coupled to heat dissipating elements via respective thermal interface materials. An air gap is formed between two heat dissipating elements connected to each other to pass air or another fluid through the gap.

In this arrangement, the circumstance is to be regarded as disadvantageous that it is comparatively difficult and expensive to exchange an individual one of the circuit boards, for instance within the scope of a repair or an update or the like.

Electronic control devices, for the cooling of which a cooling liquid is employed, are additionally described for instance in DE 10 2020 105 683 A1 and in US 2021/0222608 A1.

EP 0 316 129 B1 discloses a circuit board arrangement according to the preamble of claim 1.

It is an object of the present invention to provide a circuit board arrangement of the initially mentioned type, in which an exchange of individual circuit boards can be particularly simply accomplished.

This object is solved by a circuit board arrangement with the features of claim 1. Advantageous configurations with convenient developments of the invention are specified in the dependent claims and in the following description.

The circuit board arrangement according to the invention includes at least one housing, in which a plurality of circuit boards is arranged, and at least one cooling device, through which a cooling fluid can be passed. The at least one cooling device is formed for dissipating heat from at least one of the circuit boards. The at least one of the circuit boards is thermally coupled to the at least one cooling device by means of at least one heat transfer element. The respective circuit board is pivotable around a pivot axis from a mounting position, in which the heat transfer element abuts both on the at least one cooling device and on the circuit board, into an intermediate position. In the intermediate position, an edge area of the circuit board far from the pivot axis is further spaced from the at least one cooling device than in the mounting position. The housing comprises at least one guide element, wherein the respective circuit board is displaceable along the at least one guide element into the intermediate position in introducing the circuit board into the housing.

In such a circuit board arrangement, an exchange of individual circuit boards can be particularly simply accomplished. Because for exchanging, the circuit board can be pivoted around the pivot axis from the mounting position into the intermediate position. When the circuit board is in this intermediate position, the heat transfer element either is no longer in contact with both the cooling device and the circuit board. Rather, the heat transfer element at least largely remains in abutment with the circuit board in pivoting the circuit board into the intermediate position. Accordingly, the heat transfer element is also spaced from the cooling device in the intermediate position. Thereby, the heat transfer element does not impede or aggravate removal of the circuit board from the housing starting from the intermediate position of the circuit board.

Furthermore, the exchanged circuit board, which is intended to replace the circuit board originally arranged in the housing, can be displaced along the at least one guide element into the intermediate position without the heat transfer element arranged on the exchanged circuit board coming into contact with the cooling device herein. Thereby, this moving of the exchanged or renewed circuit board into the intermediate position also proves to be particularly simple.

In particular, an undesired shear stress of the heat transfer element does not occur in introducing the circuit board into the housing. This is due to the fact that the heat transfer element, which is applied onto the exchanged circuit board, comes into contact with the cooling device only when the circuit board is pivoted around the pivot axis from the intermediate position into the mounting position.

In exchanging or replacing the circuit board, it can in particular be provided to apply the heat transfer element onto the exchanged circuit board when the exchanged circuit board is already in the intermediate position. However, even if the heat transfer element is already on the circuit board, while the circuit board is introduced into the housing and herein is displaced into the intermediate position along the at least one guide element, the heat transfer element does not or hardly interfere with or impede this mounting step.

However, because the heat transfer element abuts both on the at least one cooling device and on the circuit board in the mounting position, the heat transfer element ensures a very efficient heat dissipation from the circuit board into the cooling device, which is passed by the cooling fluid preferably formed as a cooling liquid in the operation or cooling operation. Thereby, a very efficient heat dissipation from the circuit boards is achievable even if a plurality of circuit boards is arranged in the housing.

In particular within the scope of updates and/or repairs, a very fast exchange of the individual circuit boards can be realized. Nevertheless, the circuit boards of the circuit board arrangement are advantageously accommodated in the housing in their respective mounting position such that a very compact arrangement of the circuit boards in the housing is achieved. This is in particular advantageous if the circuit board arrangement is for example employed in a vehicle, in which the circuit boards are constituents of one or more electronic control devices or electronic control units of the vehicle.

Thus, the circumstance can in particular be taken into account that a plurality of electronic control devices or electronic control units is usually to be provided in a vehicle such as an autonomously driving vehicle and/or an electrically, in particular purely electrically, driven vehicle. Herein, the control devices can in particular take over tasks of at least one driver assistance function of the vehicle. Therefore, the arrangement of the circuit boards preferably formed as components of such control devices for a vehicle in the housing of the circuit board arrangement is advantageous.

This in particular applies if the respective electronic control devices or electronic control units have a high performance capability and thus the circuit boards of these control devices release comparatively much heat in the operation. Because the circuit boards can be arranged stacked in the housing such that the circuit boards are simply accessible. This is advantageous with regard to the simple exchange of individual circuit boards. Nevertheless, the at least one cooling device ensures an efficient heat dissipation with circuit boards brought into the mounting position.

Preferably, the respective circuit board is displaceable out of the housing along the at least one guide element starting from the intermediate position in removing the circuit board from the housing. Thereby, the removal or extraction of the circuit board from the housing within the scope of exchange of a circuit board to be exchanged proves to be particularly simple. Because the at least one guide element, which is provided on the side of the housing, can be utilized for this extraction. In addition, a well-defined movement of the circuit board both in introducing it into the housing and in removing the circuit board from the housing is thus ensured.

The heat transfer element can be formed as a heat conducting paste. This is particularly advantageous with regard to a simple application of the heat transfer element onto the circuit board in mounting the circuit board arrangement and/or within the scope of the exchange or replacement of at least one of the circuit boards with a new circuit board. Furthermore, the heat conducting paste ensures a very good thermal coupling of the circuit board to the associated cooling device.

Preferably, the heat conducting paste is spaced from the at least one cooling device in the intermediate position of the circuit board, wherein the heat conducting paste abuts on the circuit board. In this manner, it is ensured that the heat conducting paste is not exposed to undesired shear forces and in particular does not smear in introducing the circuit board into the housing at least until reaching the intermediate position of the circuit board. This is advantageous with regard to a correct positioning of the heat conducting paste on the circuit board on the one hand. On the other hand, the introduction of the circuit board into the housing is thus not impeded or aggravated by undesired smearing or spreading of the heat conducting paste in displacing the circuit board along the at least one guide element.

Preferably, the respective circuit board is arranged on a support plate, which is displaceable along the at least one guide element. On the one hand, such a support plate formed in the manner of a drawer ensures a particularly simple handling of the circuit board in introducing the same into the housing and also in removing the circuit board from the housing. In addition, providing the support plate increases the stability of an assembly, which includes the support plate and the circuit board arranged on the support plate.

In particular, the support plate can be formed as a sheet metal component, on which the circuit board is retained, for example by screwing and/or clipping and/or the like types of fixing the circuit board to the support plate. With formation of the support plate as a sheet metal component, the support plate is very robust and of advantageously low weight at the same time. And by fixing the circuit board to the support plate, the circuit board is prevented from being able to slip on the support plate.

Preferably, the support plate comprises at least one locking element, which is engaged with a counterpart provided on the side of the housing in the mounting position of the circuit board. By the engagement of the locking element with the counterpart, well-defined and process-reliable reaching of the mounting position can be simply realized.

In addition, the locking element can be formed particularly robust by providing it at the support plate. This is advantageous with regard to high durability of a locking mechanism, which is provided by the engagement of the locking element with the counterpart.

For example, the locking element can be formed as a locking lug, which engages with a recess formed in the housing. However, in analogous manner, the locking element can also be formed as a recess, which engages in the mounting position of the circuit board with a counterpart formed as a projection.

Preferably, the support plate comprises at least one stud element, by which the pivot axis is formed. In this manner, the pivot axis can be locally precisely, simply and functionally reliably provided.

Preferably, the at least one stud element is received in a locking depression provided on the side of the housing both in the mounting position and in the intermediate position of the circuit board. Thus, in inserting the support plate into the housing, reaching the intermediate position of the circuit board can be very simply, preferably haptically and/or acoustically, ascertained by a person involved in the introduction of the circuit board into the housing. In addition, the circuit board is particularly well secured against slipping along the at least one guide element in the intermediate position by providing the locking depression.

Preferably, the locking depression is formed in an end area of the at least one guide element. Thereby, a very compact construction of the circuit board arrangement arises.

Preferably, the circuit board arrangement comprises retaining means, which are formed for retaining the at least one cooling device with the circuit board pivoted into the intermediate position. By providing the retaining means, it can be ensured that the cooling device remains stationary even if the circuit board is pivoted into the intermediate position and in particular subsequently removed from the housing. In addition, the at least one cooling device can thus be installed or arranged in the housing independently of the at least one circuit board, which is coolable by means of the cooling device with intervention of the heat transfer element. This is advantageous with regard to a high flexibility in mounting the circuit board arrangement.

In particular, the housing can comprise the retaining means, which are formed for retaining the at least one cooling device with the circuit board pivoted into the intermediate position. As such retaining means, for example retaining bars or the like webs, on which the cooling device rests, can be formed on the housing. Additionally or alternatively, it is possible to fix the circuit board arrangement to the housing by screwing and/or by locking or the like. Accordingly, the retaining means can additionally or alternatively be provided by corresponding locking elements and/or screws and/or the like fixing means, which ensure fixing the cooling device to the housing, while the circuit board is pivoted into the intermediate position or is in the intermediate position.

Preferably, the at least one guide element is provided by respective guide rails, which are formed on sidewalls of the housing opposing each other. Thus, a particularly secure guide of the circuit board and of the support plate retaining the circuit board, respectively, can be achieved in displacing along the guide rails. In addition, providing the guide rails facilitates the handling of the circuit board and of the support plate, respectively, during displacement.

Preferably, the guide rails are oriented inclined related to a bottom wall of the housing. Because then, with arrangement of the at least one cooling device at least substantially parallel to the bottom wall of the housing, the displacement of the circuit board along these inclined guide rails into the intermediate position or out of the intermediate position can be particularly simply realized.

Preferably, circuit boards arranged above each other in a vertical direction of the housing in the mounting position are connected to a further circuit board by means of a respective connecting element, wherein the further circuit board is arranged on a rear side of the housing. The rear side is opposing a front-side access opening of the housing. In this manner, the connection of the circuit boards to the further circuit board can be realized at the same time by bringing the circuit boards into the mounting position. This is advantageous with regard to simplified mounting of the circuit board arrangement.

Preferably, the circuit board arrangement comprises a plurality of assemblies, wherein a respective assembly includes a cooling device and at least one circuit board coolable by means of this cooling device. Herein, a clearance is formed between adjacent assemblies. Thereby, space is present between the assemblies on the one hand in order to pivot the circuit board from the mounting position into the intermediate position. On the other hand, the clearance allows a simple access to the respective assembly, and the clearance ensures improved heat dissipation.

It can be provided that the assemblies can be introduced into the housing and/or removed from the housing independently of each other. In this manner, it is possible, in particular within the scope of a first equipment of the housing with cooling devices and circuit boards, to introduce the already premounted assembly into the housing. This is conducive to effective and fast mounting. And if the assembly, which includes the cooling device, is removable from the housing together with the circuit board, thus, the cooling device can be exchanged together with the circuit board as needed. This is also advantageous, for instance for maintenance or repair or the like.

Preferably, the at least one cooling device includes a first side, which faces a first circuit board, and a second side, which faces a second circuit board. Herein, the first circuit board and the second circuit board are thermally coupled to the same cooling device by means of a respective heat transfer element. By such an arrangement of the two circuit boards on the sides of the at least one cooling device opposing each other, a cooling performance of the cooling device can be very efficiently used for cooling a plurality of circuit boards.

Preferably, respective structural elements are arranged on sidewalls of the housing opposing each other in transverse direction of the housing, wherein the respective structural elements comprise at least bearing areas for the at least one cooling device. Herein, bearing areas, which are lower ones in vertical direction of the housing, have a smaller distance from each other in transverse direction than bearing areas, which are upper ones in vertical direction of the housing. Thus, it can be ensured that only an exactly fitting cooling device or a cooling device, the size of which corresponds to the distance of the bearing areas from each other, can be arranged in the respective height position of the housing. In particular, an order in installing the cooling devices in the housing can be very simply preset in this manner.

I this manner, it can additionally be ensured corresponding to a poka-yoke principle that the respective cooling device can only be arranged at the place in the housing intended hereto. This is advantageous with regard to a correct mounting order of the components of the circuit board arrangement and an overall correct mounting of the circuit board arrangement.

The bearing areas can comprise screwing openings and/or receptacles for retaining pins or the like to allow fixing at least of the cooling devices in the bearing areas at the structural elements. Thus, secure and simple fixing of the cooling devices in the housing can be achieved.

In analogous manner as described for the cooling devices, the structural elements can have distances from each other in transverse direction in a respective height position, which allow the arrangement of only one circuit board exactly corresponding to the respective distance in this height position. In this manner, it can be ensured that the circuit boards associated with the respective cooling device either can only be arranged in a predetermined mounting order and/or in a predetermined position in the housing. This too, is advantageous with regard to correct and process-reliable mounting in manufacturing the circuit board arrangement.

The installation of the cooling devices and/or the circuit boards from above in the housing in vertical direction of the housing in an order preset by the structural elements entails further advantages. By this installation order, in which these components are introduced into the housing from above, it can in particular be well ensured that the respective heat transfer element can be simply and purposefully placed between the respective cooling device and the at least one circuit board, which is associated with this cooling device.

The circuit board arrangement can include a plurality of housings. Thus, scaling of the circuit board arrangement can be very simply achieved. In particular, the housings of the circuit board arrangement can be fixed to each other. Thus, a modular construction of the circuit board arrangement can be very simply realized on the one hand. Furthermore, stationary positioning of the respective housings is achieved in this manner.

The arrangement of the housings in relation to each other can be such that the sidewalls of adjacent housings abut on each other. Additionally or alternatively, at least one sidewall of a first one of the housings can abut on a bottom wall and/or on a ceiling wall of at least a second one of the housings. In this manner, it is possible to simply and very largely account for the installation space conditions to be considered for accommodating the housings.

If the circuit board arrangement includes a plurality of housings, in particular fixed to each other, it can be provided that the housings are stacked on top of each other such that sidewalls of adjacent housings are arranged aligned with each other. This allows a good access to the circuit boards and the assemblies including the circuit boards, respectively, such that an exchange of the circuit boards and/or the assemblies can in particular be simply realized.

By such a modular construction of the circuit board arrangement including a plurality of the housings, any arrangements of the circuit boards in the housing and of the assemblies including the circuit boards within the housings, respectively, can be realized in a simple and flexible manner.

In the housing, at least two circuit boards arranged above each other can be arranged between two cooling devices in a sandwich-like construction. Thus, a very good heat dissipation from the circuit boards via the two cooling devices is allowed. Additionally or alternatively, two cooling devices arranged above each other can be arranged between two circuit boards in a sandwich-like construction. This too, is advantageous with regard to an effective heat dissipation from the circuit boards.

Further features of the invention are apparent from the claims, the figures and the description of figures. There show:
- Fig. 1: a circuit board arrangement during mounting in a schematic perspective view, wherein inclined guide rails are formed on sidewalls of a housing of the circuit board arrangement;
- Fig. 2: a side view of the circuit board arrangement according to Fig. 1;
- Fig. 3: schematically the circuit board arrangement according to Fig. 1, wherein a cooling device is located in the housing in its intended installation position or mounting position, while a circuit board arranged on a support plate is just being displaced along the guide rails;
- Fig. 4: an exploded representation of the circuit board arrangement according to Fig. 1;
- Fig. 5: the housing of the circuit board arrangement according to Fig. 1 in a perspective view;
- Fig. 6: the circuit board arrangement according to Fig. 1 in a sectional view, wherein the individual circuit boards and the cooling devices are in their respective mounting positions;
- Fig. 7: the circuit board arrangement according to Fig. 6 in a perspective view;
- Fig. 8: in an exploded representation, a variant of the circuit board arrangement, in which structural elements are arranged on the sidewalls of the housing, which preset a mounting order of the circuit boards and the cooling devices in introducing the same into the housing from above and an installation position in the housing;
- Fig. 9: the housing of the circuit board arrangement according to Fig. 8 in a perspective view;
- Fig. 10: the circuit board arrangement according to Fig. 8 in the assembled state;
- Fig. 11: a circuit board arrangement, in which two housings formed according to Fig. 8 are arranged next to each other, wherein sidewalls of the housings abut on each other;
- Fig. 12: a variant of the arrangement of two housings, formed according to Fig. 8, of the circuit board arrangement, wherein the sidewall of a first one of the housings abuts on a ceiling wall of a second one of the housings;
- Fig. 13: further variants of housings of the circuit board arrangement, wherein assemblies including circuit boards are arranged in different orientations in relation to each other in the respective housings; and
- Fig. 14: the housings according to Fig. 13 in a state coupled to each other, wherein the sidewalls of adjacent housings of the circuit board arrangement are arranged aligned with each other.

In the figures, identical or functionally identical elements are provided with identical reference characters.

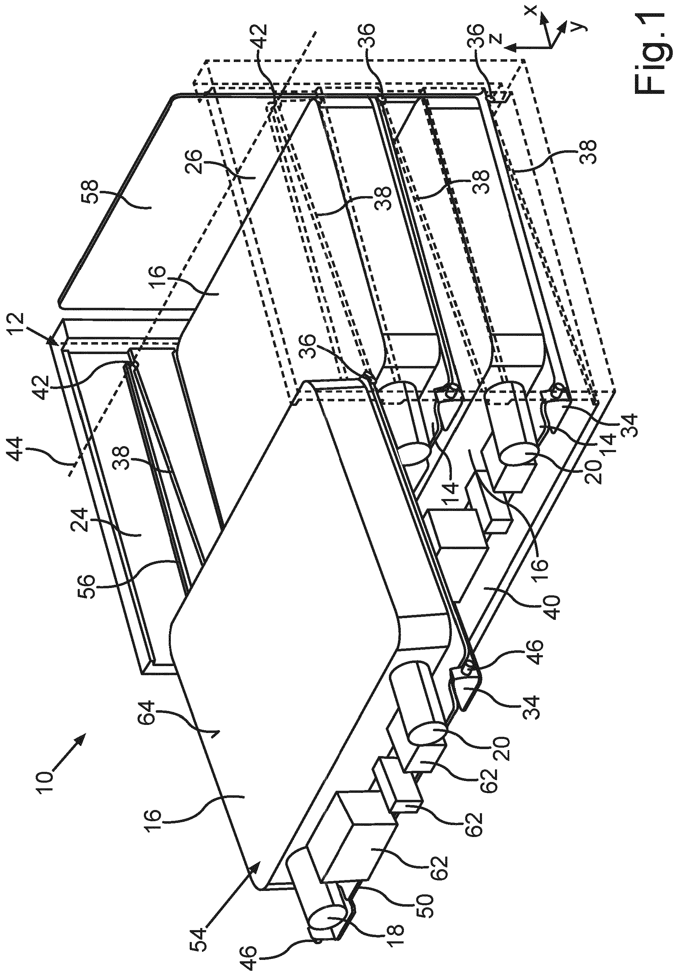

Fig. 1 shows a circuit board arrangement 10 with a housing 12, in which a plurality of circuit boards 14 is arranged, in a schematic and perspective manner. Viewed in vertical direction z of the housing 12, the circuit boards 14 are arranged above each other in the housing 12. The circuit boards 14 can in particular be constituents of one or more electronic control devices or electronic control units of a vehicle, which is equipped with the circuit board arrangement 10.

Two of the circuit boards 14 exemplarily and schematically shown in Fig. 1 are shown in their mounting position or installation position in the housing 12, namely the two circuit boards 14, which are the lower ones viewed in vertical direction z. In contrast, the third one of the three circuit boards 14 exemplarily shown in Fig. 1 is just being pushed into the housing 12, namely substantially in a depth direction x of the housing 12. The depth direction x as well as the vertical direction z and the transverse direction y of the housing 12 is schematically illustrated by a coordinate system in Fig. 1.

In the construction of the circuit board arrangement 10 shown in Fig. 1, an own cooling device 16 is associated with each of the circuit boards 14, through which a cooling fluid can be passed, in particular in the form of a liquid coolant or a cooling liquid. For this purpose the respective cooling device 16 formed in the manner of a cooling plate comprises a coolant inlet 18 and a coolant outlet 20, wherein not each of the coolant inlets 18 and each of the coolant outlets 20 are provided with a reference character for reasons of clarity in Fig. 1.

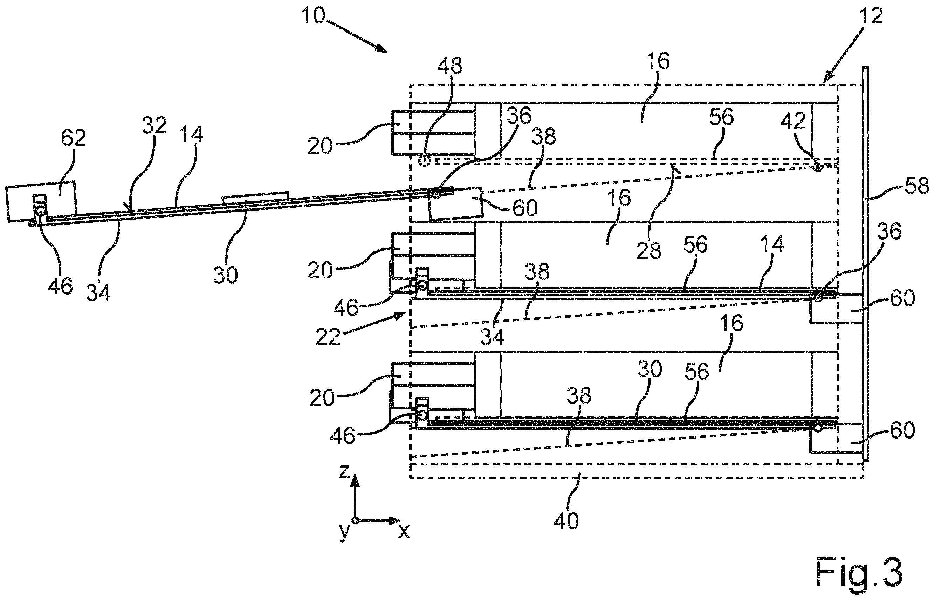

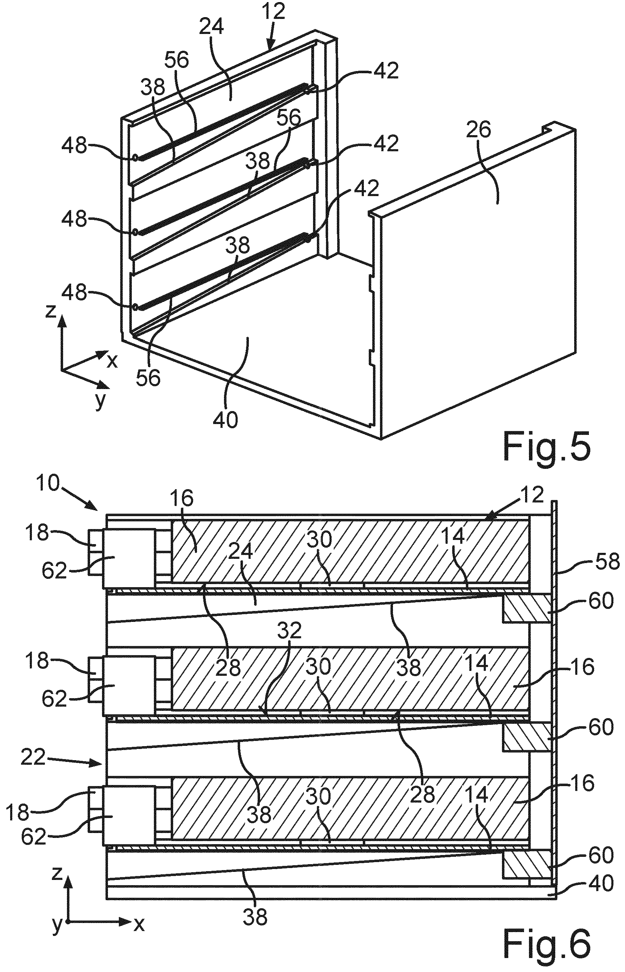

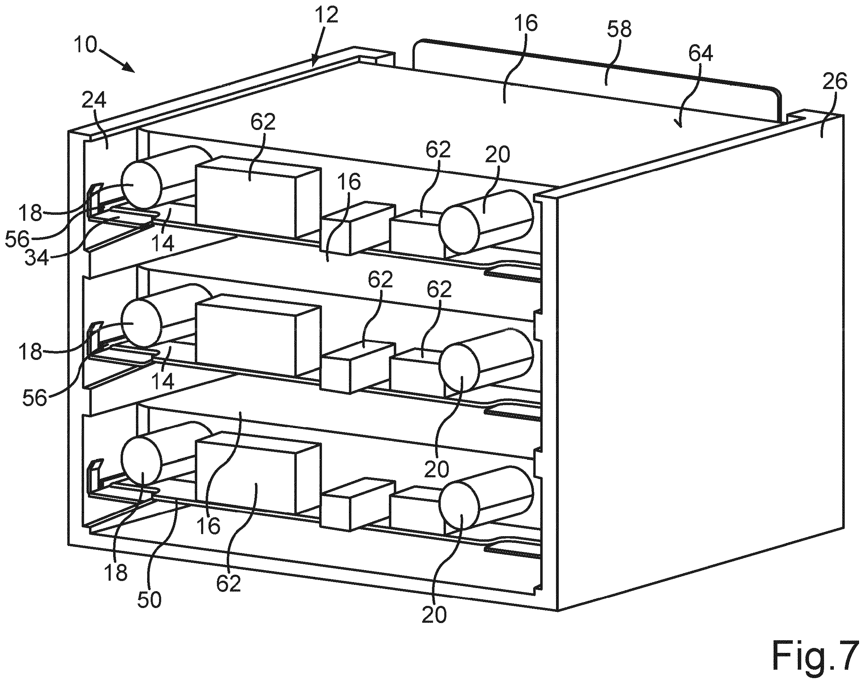

It is apparent in particular from Fig. 3, from Fig. 7 and from the sectional view of the circuit board arrangement 10 according to Fig. 6 that when the cooling devices 16 are in their mounting position, in which the cooling devices 16 are arranged above each other in the housing 12 in vertical direction z of the housing, the respective coolant inlet 18 and the respective coolant outlet 20 are accessible via a front-side access opening 22 of the housing 12. Herein, the respective coolant inlet 18 and the respective coolant outlet 20 protrude beyond front-side edges of sidewalls 24, 26 of the housing 12. The sidewalls 24, 26 of the housing 12 are opposing each other in transverse direction y of the housing 12.

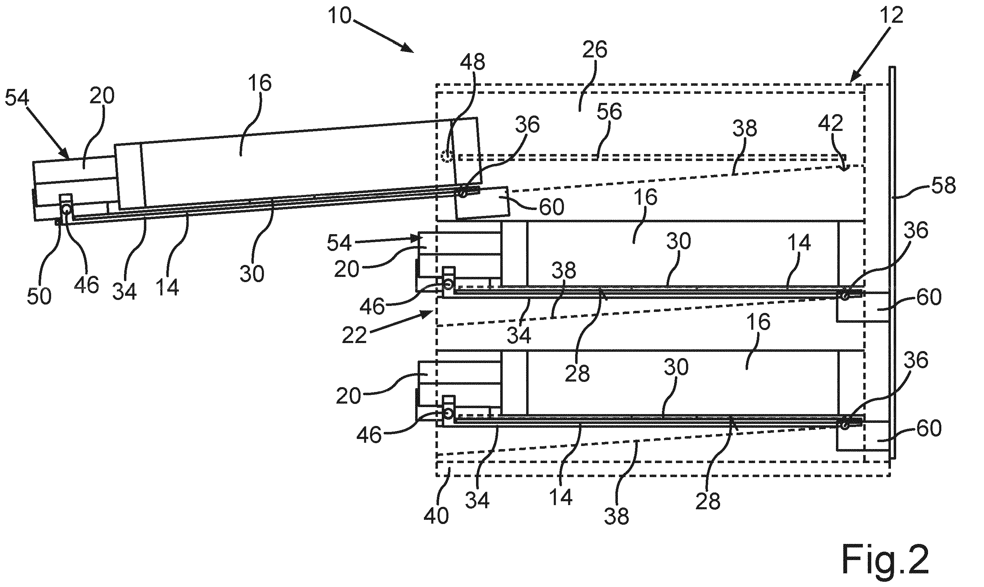

It is apparent in particular from Fig. 2 and from Fig. 6 that the respective circuit boards 14 do not directly and extensively abut on respective bottom sides 28 of the cooling devices 16, which are associated with the respective circuit board 14. Rather, the respective circuit board 14 is thermally coupled to the respective cooling device 16 by means of at least one heat transfer element 30. The at least one heat transfer element 30 is presently formed as a heat conducting paste.

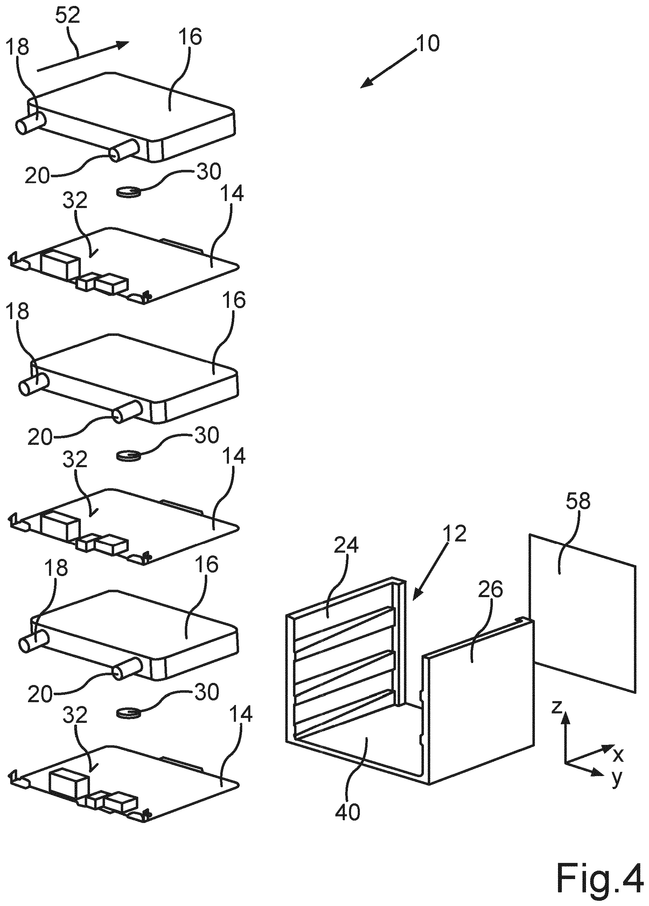

From the exploded representation of the circuit board arrangement 10 in Fig. 4, it is also apparent that the respective heat transfer elements 30 are formed in the form of respective portions of the heat conducting paste between the bottom sides 28 of the respective cooling device 16 and top sides 32 of the respective circuit boards 14 facing these bottom sides 28. The heat transfer elements 30 presently in the form of the heat conducting paste ensure good thermal coupling of the circuit boards 14 to the respective cooling device 16. Thereby, heat released in the operation of the circuit boards 14 can be well dissipated via the coolant, which flows through the cooling devices 16 in the operation or cooling operation of the cooling devices 16.

In the manufacture of the circuit board arrangement 10, the housing 12 can be equipped with the circuit boards 14 and the respective cooling device 16 associated with at least one of the circuit boards 14, as it is apparent from Fig. 1 and Fig. 2. Accordingly, the respective circuit board 14 can be arranged on a support plate 34 formed in the manner of a drawer, wherein the cooling device 16 is arranged on the respective circuit board 14 with interposition of the heat transfer element 30. Preferably, the respective circuit board 14 is fixed to the respective support plate 34, for example by screwing and/or locking or the like.

The respective support plate 34 comprises respective stud elements 36, which serve as guide studs or guide pins, on its narrow sides, which are opposing the sidewalls 24, 26 of the housing 12 in transverse direction y of the housing 12 (see in particular Fig. 2 and Fig. 3). These stud elements 36 can be displaced along guide elements of the housing 12, which are presently provided by guide rails 38. Herein, the guide rails 38 are formed on the sidewalls 24, 26 of the housing 12, which are opposing each other in transverse direction y of the housing 12 (see Fig. 5). It is well apparent in particular from Fig. 5 that these guide rails 38 are oriented inclined related to a bottom wall 40 of the housing 12.

The stud elements 36 can be displaced along these guide rails 38 until the respective stud elements 36 are received in locking depressions 42, which are formed in an end area of the respective guide rail 38. The locking depressions 42 formed in the rear end area of the guide rails 38 are well apparent in particular from the perspective view of the housing 12 in Fig. 5.

In introducing the support plates 34 into the housing 12, the circuit boards 14 are also displaced along the guide elements presently formed as the guide rails 38. When the stud elements 36 are then received in the locking depressions 42, the respective support plate 34 and thus also the respective circuit board 14 is in an intermediate position. In this intermediate position of the circuit board 14, the respective circuit board 14 - and presently also the support plate 34 - is oriented inclined related to the bottom wall 40 of the housing 12.

In contrast, the circuit boards 14 are oriented substantially parallel to the bottom plate or bottom wall 40 in the mounting position of the respective circuit board 14 (see Fig. 2 and Fig. 6). In order to move the respective circuit board 14 from the intermediate position into the mounting position, the support plate 34 and thus also the respective circuit board 14 at the same time can be pivoted around a pivot axis 44, which is formed by the stud elements 36 and the approximate position of which is schematically indicated in Fig. 1 in the area of two locking depressions 42 opposing each other in transverse direction y of the housing.

Pivoting the support plate 34 and the circuit board 14 together with it from the intermediate position into the mounting position results in a locking element presently formed as a locking pin 46 engaging with a counterpart, which is formed as a locking opening 48. The locking openings 48, which correspond to the locking pins 46 of the respective support plate 34, are formed in the respective sidewall 24, 26 of the housing 12. The locking openings 48, which are formed in the left sidewall 24 according to Fig. 5, are well apparent in particular in Fig. 5.

When the locking pins 46 of the respective support plate 34 are received in the associated or corresponding locking openings 48, thus, the respective circuit board 14 is in its mounting position. When the respective circuit board 14 is in the mounting position, the at least one heat transfer element 30 arranged on the respective circuit board 14 abuts on the bottom side 28 of the respective cooling device 16. From this mounting position, the support plate 34 and with it the circuit board 14 arranged on the support plate 34 can be pivoted around the pivot axis 44 into the intermediate position, while the cooling device 16 remains stationary. This is illustrated in Fig. 3.

In the intermediate position of the support plate 34 and thus also of the circuit board 14, an edge area 50 of the circuit board 14 far from the pivot axis 44 is further spaced from the cooling device 16 than in the mounting position. Thus, in the intermediate position, the circuit board 14 is, presently together with the support plate 34, pivoted a little bit downwards around the pivot axis 44. Accordingly, a clearance is present between the top side 32 of the circuit board 14 and the bottom side 28 of the cooling device 16. This clearance becomes increasingly larger from the pivot axis 44 towards the access opening 22 of the housing 12.

Due to the formation of this clearance between the top side 32 of the circuit board 14 and the bottom side 28 of the cooling device 16, in exchanging the circuit board 14, it is possible to arrange the heat transfer element 30 presently in the form of the heat conducting paste on the top side 32 of the circuit board 14 and then to displace the circuit board 14 into the intermediate position without the heat transfer element 30 coming into contact with the bottom side 28 of the cooling device 16. This is apparent in particular from Fig. 3.

Namely, a step during equipment of the housing 12 with an exchanged or renewed circuit board 14 is shown in Fig. 3. In this mounting step, the cooling device 16 can remain in its mounting position, in which the bottom side 28 of the cooling device 16 is oriented substantially parallel to the bottom wall 40. The stud elements 36 are displaced along the guide elements presently in the form of the guide rails 38 in a mounting direction, which is illustrated by an arrow 52 in Fig. 4. The mounting direction presently extends parallel to the guide rails 38.

In this movement of the circuit board 14 in the mounting direction along the guide rails 38 into the intermediate position, the heat transfer element 30 presently in the form of the heat conducting paste is prevented from coming into contact with the bottom side 28 of the cooling device 16 before the support plate 34 and the circuit board 14 together with it have reached the intermediate position.

When the support plate 34 is then pivoted together with this circuit board 14 arranged on the support plate 34 from the intermediate position into the mounting position, thus, the heat transfer element 30 comes in abutment with the bottom side 28 of the cooling device 16 (see Fig. 3). Therefore, in the mounting position of the respective circuit board 14, the heat transfer element 30 abuts both on the cooling device 16 and on the circuit board 14 (see Fig. 6).

Thus, if at least one of the circuit boards 14 is to be exchanged, the circuit board 14 can first be pivoted around the pivot axis 44 into the respective intermediate position, in which the heat transfer element 30 is spaced from the bottom side 28 of the cooling device 16.

However, both in extracting or removing the circuit board 14 from the housing 12 and in subsequent introduction of the exchanged, for example updated, circuit board 14 into the housing 12, smearing or spreading the heat transfer element 30 presently formed as the heat conducting paste can be prevented, which is arranged on the top side 32 of the circuit board 14. Thereby, the exchange of individual circuit boards 14 can be particularly simply accomplished.

Even if a part or remainder of the heat conducting paste should remain on the bottom side 28 of the cooling device 16 in moving the support plate 34 and thus also the circuit board 14 from the mounting position into the intermediate position, this heat conducting paste remaining in the housing 12 impedes neither the removal of the circuit board 14 from the housing 12 nor the equipment of the housing 12 with the renewed and/or updated and/or repaired circuit board 14, on which a new portion or amount of heat conducting paste is preferably arranged.

In particular in equipping the housing 12 with the cooling devices 16 and the circuit boards 14 for the first time, it can be proceeded as it is shown in Fig. 1 and in Fig. 2. Herein, an assembly 54, which presently includes the circuit board 14 and the cooling device 16 associated with this circuit board 14, can be pushed into the housing 12. Herein, the circuit board 14 is already thermally coupled to that cooling device 16, which is associated with the respective circuit board 14, by means of the heat transfer element 30 according to Fig. 2.

According to Fig. 1 and Fig. 2, the assembly 54 can also include the support plate 34, which is formed in the manner of the drawer in particular formed of a sheet metal. In exchanging the circuit board 14 for instance for the purpose of maintenance and/or update in particular of the circuit board 14, the entire assembly 54 can therefore also be removed or extracted from the housing 12.

However, it is in particular possible that in exchange of at least one of the circuit boards 14, it is proceeded as it is illustrated in Fig. 3. Accordingly, the cooling device 16 associated with the respective circuit board 14 can remain stationary in the housing 12, and only the circuit board 14 arranged on the support plate 34 is removed or extracted from the housing 12 together with the support plate 34.

In this extraction of the circuit board 14 from the housing 12, the support plate 34 and accordingly also the circuit board 14 together with the support plate 34 is displaced out of the housing 12 along the guide elements presently provided by the guide rails 38, namely opposite to the direction which is illustrated by the arrow 52 in Fig. 4.

In introducing the exchanged circuit board 14 into the housing 12, the circuit board 14 can then be displaced into the intermediate position along the guide elements presently in the form of the guide rails 38 in that the stud elements 36 slide along on the guide rails 38 until the stud elements 36 get into the locking depressions 42, which are formed in the end area of the respective guide rail 38.

Only by pivoting the support plate 34 and thus also the circuit board 14 into the mounting position, the contact of the heat transfer element 30 arranged on the top side 32 of the circuit board 14 with the bottom side 28 of the cooling device 16 already arranged in the housing 12 is then established.

This type of mounting in particular of updated and/or renewed and/or repaired circuit boards 14 can be particularly simply realized due to the inclined orientation of the guide rails 38 of the circuit board arrangement 10. The orientation of the guide rails 38 inclined to the bottom wall 40 or bottom plate of the housing 12 is in particular apparent from Fig. 5.

If the support plate 34 was not displaced along the inclined oriented guide rails 38 into the housing 12, but parallel to the bottom side 28 of the cooling device 16 or perpendicularly to the vertical, thus, this would result in undesired smear of the heat conducting paste, which is presently prevented in an advantageous manner.

Nevertheless, the circuit boards 14 are stacked above each other and arranged well accessible in the housing 12 formed in the manner of a rack in the mounting position. In addition, a good heat dissipation from the circuit boards 14 in the operation thereof is achievable by providing the cooling devices 16. The circuit boards 14 can be associated with respective control entities or control devices. By the arrangement of a plurality of such electronic control devices or electronic control units in the housing 12, a compact construction of the circuit board arrangement 10 including multiple such control devices is advantageously achieved.

It is apparent in particular from Fig. 2, but also from Fig. 3, that the stud elements 36 are received in the locking depressions 42, which are formed in the end areas of the guide rails 38, both in the mounting position of the circuit boards 14 and in the intermediate position of the circuit boards 14.

It is apparent in particular from Fig. 1 and from Fig. 5 that the circuit board arrangement 10, presently the housing 12, comprises retaining means, which are formed for retaining the cooling devices 16 with circuit boards 14 pivoted into the intermediate position. According to Fig. 5, the retaining means include retaining bars 56, on which the cooling devices 16 can rest when the cooling devices 16 are pushed into the housing 12 in depth direction x. In particular in Fig. 5, the retaining bars 56 arranged on the left sidewall 24 according to Fig. 5, are well recognizable.

Additionally or alternatively to the retaining bars 56, other and/or further retaining means can fix the cooling devices 16 in the housing 12 in their position. For example, the cooling devices 16 can be connected to the sidewalls 24, 26 by screwing and/or by locking and thus be retained in the housing 12 when the circuit board 14 is pivoted presently together with the support plate 34 from the mounting position (see Fig. 6) into the intermediate position. Corresponding locking elements and/or screw bolts for providing the retaining means are presently not shown in more detail for reasons of clarity.

It is further apparent from Fig. 1 that a further circuit board 58, which is presently oriented substantially parallel to a plane spanned by the vertical direction z and the transverse direction y, can be arranged on a rear side of the housing 12, which is opposing the front-side access opening 22. The arrangement of the further circuit board 58 preferably serving as a main circuit board on the rear side of the housing 12, which is opposing the front-side access opening 22 in depth direction x of the housing 12, is also well apparent from the exploded representation of the circuit board arrangement 10 in Fig. 4.

On a rear end of the respective circuit board 14, the circuit boards 14 presently comprise connecting elements 60. When the circuit boards 14 are in their mounting position (see Fig. 6 and Fig. 7), thus, the circuit boards 14 are connected to the further circuit board 58 via these rear connecting elements 60.

In contrast, further connecting elements 62 of the circuit boards 14 are accessible from the front-side access opening 22 of the housing 12, via which data and/or electrical energy for or from respective components (presently not shown in more detail) of the circuit boards 14 can be provided. These front-side connecting elements 62 or connections are in particular well apparent in the perspective view of the circuit board arrangement 10 according to Fig. 7.

It is well apparent from the sectional view in Fig. 6 and from the perspective view in Fig. 7 that a clearance is formed between the individual assemblies 54, which include the respective cooling device 16 and at least one circuit board 14 coolable by means of this cooling device 16. Due to the size of the clearance, it presently proves to be particularly simple to pivot the circuit board 14 around the pivot axis 44 from the mounting position (see Fig. 7) into the intermediate position, in which the edge area 50 of the respective circuit board 14 is further spaced from the cooling device 16 than in the mounting position.

In variants of the circuit board arrangement 10 presently not shown in more detail, it can be provided that not only the bottom side 28 and thus a first side of the cooling device 16 is used for cooling a respective circuit board 14, but also a second side presently in the form of a top side 64 of the respective cooling device 16 or at least one of the cooling devices 16.

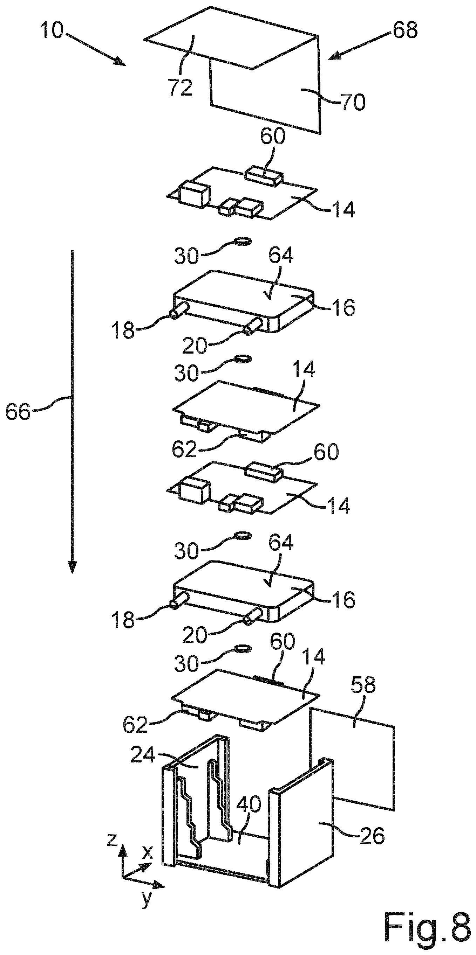

Such a use of a cooling device 16 for cooling two circuit boards 14 is to be explained with reference to Fig. 8. Here too, the further circuit board 58 serving as the main circuit board is arranged on the rear side of the housing 12. However, one of the circuit boards 14 is thermally coupled to the cooling device 16 by means of the heat transfer element 30 not only on the bottom side 28 of the respective cooling device 16. Rather, at least one further heat transfer element 30 preferably in the form of the heat conducting paste is also arranged between a top-side circuit board 14 and the top side 64 of the respective cooling device 16.

According to Fig. 8, the circuit boards 14 and the cooling devices 16 can be introduced into the housing 12 together with the heat transfer elements 30 respectively interposed therebetween opposite to the vertical direction z of the housing 12. A corresponding mounting direction is illustrated by an arrow 66 in Fig. 8. Here too, it proves to be very simple to arrange the heat transfer elements 30 respectively between the circuit boards 14 and the respective sides in the form of the bottom side 28 and the top side 64 of the cooling devices 16. Because the circuit board 14, the heat transfer elements 30 and the cooling devices 16 can be successively introduced into the housing 12 from above corresponding to the direction illustrated by the arrow 66.

Also in the variant of the circuit board arrangement 10 shown in Fig. 8, the cooling devices 16 each comprise the coolant inlet 18 and the coolant outlet 20, via which the coolant, in particular in the form of the cooling liquid, can be passed through the respective cooling device 16.

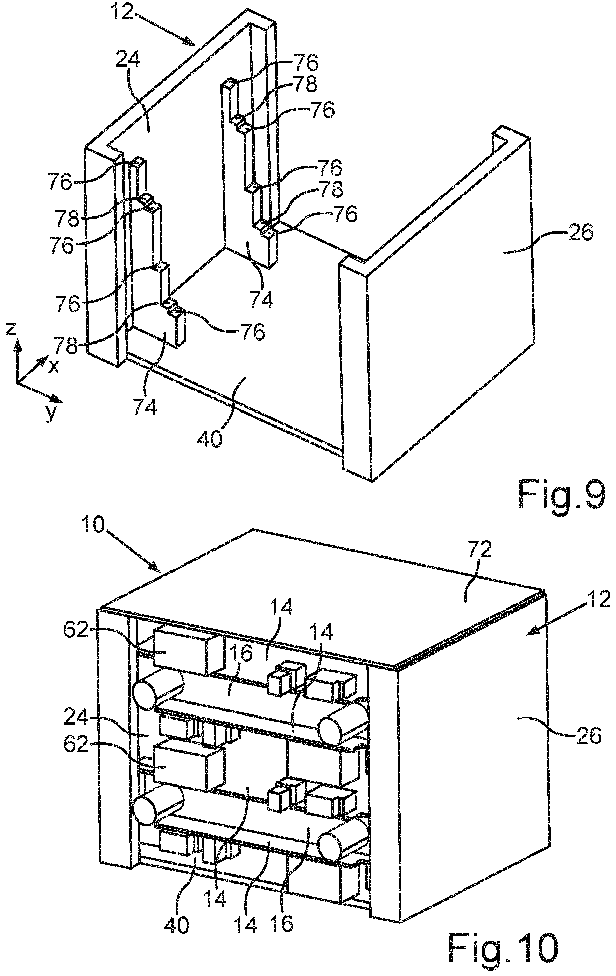

In Fig. 8, a cover 68 presently formed L-shaped in cross-section is additionally shown, via which a rear wall 70 and a ceiling wall 72 of the housing 12 are formed in the mounted state of the circuit board arrangement 10 (see Fig. 10).

It is apparent in particular from Fig. 9 that structural elements 74 can be arranged on the sidewalls 24, 26 of the housing 12 opposing each other in transverse direction y, by which a mounting order in introducing the circuit boards 14 and the cooling devices 16 into the housing 12 from above, thus, in the direction of the arrow 66 (see Fig. 8), is preset.

By the columnar structural elements 74, a poka-yoke principle for correct arrangement of the circuit boards 14 and the cooling devices 16 in the housing 12 is ensured. For this purpose the structural elements 74 comprise bearing areas 76 for the respective circuit board 14 on the one hand, which are formed in the manner of top sides of respective steps of the structural elements 74. In analogous manner, the columnar structural elements 74 comprise further bearing areas 78, on which the bottom sides 28 of the respective cooling device 16 rest when the circuit boards 14 and the cooling devices 16 are arranged in the housing 12.

In vertical direction z of the housing 12, lower bearing areas 78 for the respective cooling device 16 have a smaller distance from each other than bearing areas 78, which are upper ones in vertical direction z of the housing 12. Herein, the distance is measured in the transverse direction y of the housing 12. Accordingly, the cooling device 16, which is the lower one in Fig. 8, can only be laid on the lower bearing areas 78. In contrast, the cooling device 16, which is the upper one in Fig. 8, can only be laid on the upper bearing areas 78. Accordingly, an installation position and an installation order of the respective cooling device 16 in the housing 12 are preset by the distances of the bearing areas 78 from each other in transverse direction y.

In analogous manner, the bearing areas 76 for the respective circuit boards 14 can have increasingly larger distances from each other in vertical direction z of the housing 12, wherein the distances are measured in transverse direction y of the housing 12. Thereby, it is ensured that the respective circuit board 14 can also only be arranged in a predetermined height position in the housing 12.

For fixing the components presently in the form of the circuit boards 14 and the cooling devices 16 at the respective level of the housing 12 or the structural elements 74, screwing openings and/or plug-in openings or the like can for example be provided in the bearing areas 76, 78. By introducing screws into the screwing openings or screwing holes or pins into the plug-in openings, a simply detachable fixing of the circuit boards 14 and the cooling devices 16 in the housing 12 can be achieved.

Due to the mounting order preset by the structural elements 74 in introducing the circuit boards 14 and the cooling devices 16 into the housing 12, an exchange of the circuit boards 14 and introduction of the heat transfer elements 30 between the circuit boards 14 and the respective cooling device 16 can also be simply realized.

The sandwich-like construction in the arrangement of the respective cooling device 16 between the respectively lower circuit board 14 and the respectively upper circuit board 14 in the housing 12 is well apparent from Fig. 10.

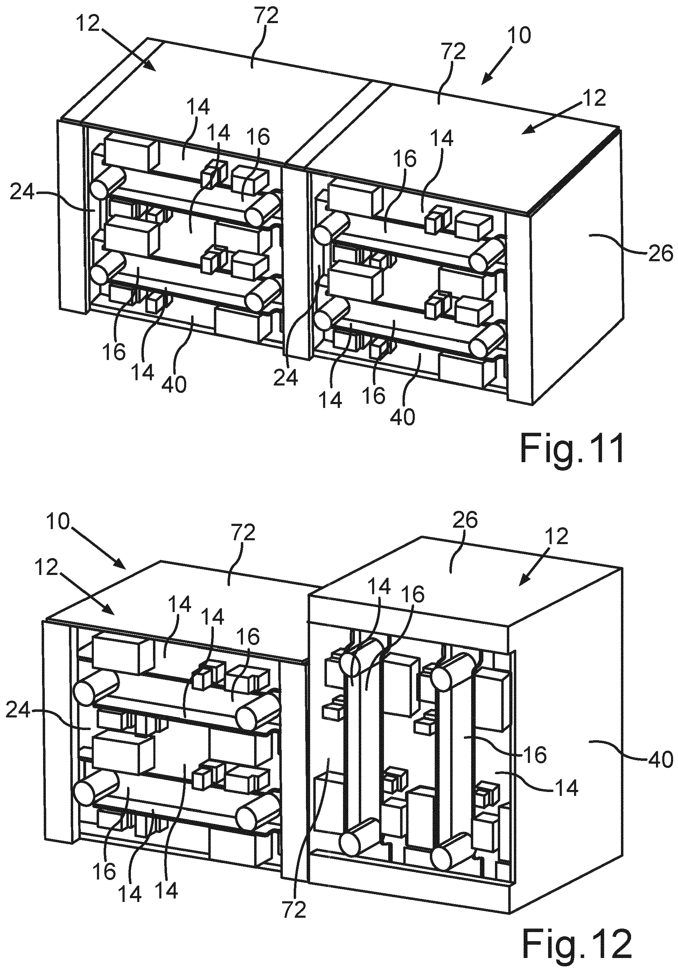

It is apparent from Fig. 11 that the circuit board arrangement 10 can include a plurality of housings 12, wherein the housings 12 can in particular be fixed to each other. Herein, the sidewalls 24, 26 of adjacent housings 12 can abut on each other according to Fig. 11. For example, the sidewall 26, which is the right one in Fig. 11, of the housing 12, which is the left one in Fig. 11, can abut on the sidewall 24, which is the left one in Fig. 11, of the housing 12, which is the right one in Fig. 11.

However, other types of an arrangement and/or fixing of the housings 12 to each other are also possible. This is to be explained with reference to Fig. 12. In the arrangement according to Fig. 12, the sidewall 26, which is the right one in Fig. 12, of the first housing 12 abuts on the ceiling wall 72 of the second housing 12. Additionally or alternatively, it can be provided that one of the sidewalls 24, 26 of the first housing 12 or housing 12, which is the left one in Fig. 12, abuts on the bottom wall 40 of the housing 12, which is the right one in Fig. 12.

In such circuit board arrangements 10, horizontal arrangements of the cooling devices 16 and of the circuit boards 14 (see Fig. 11) and/or vertical arrangements of the cooling devices 16 and/or of the circuit boards 14 (see Fig. 12) can in particular be provided in respectively desirable combinations.

Additionally or alternatively, the circuit board arrangement 10 can comprise a double housing or the like multi-housing, in which the housings 12 shown in Fig. 11 or Fig. 12 are formed integrally with each other.

In the respective housings 12 according to Fig. 11 and Fig. 12, the sandwich-like construction with the arrangement of the cooling devices 16 between the respective circuit boards 14 is realized as it was explained with reference to Fig. 8 to Fig. 10 for one of the housings 12.

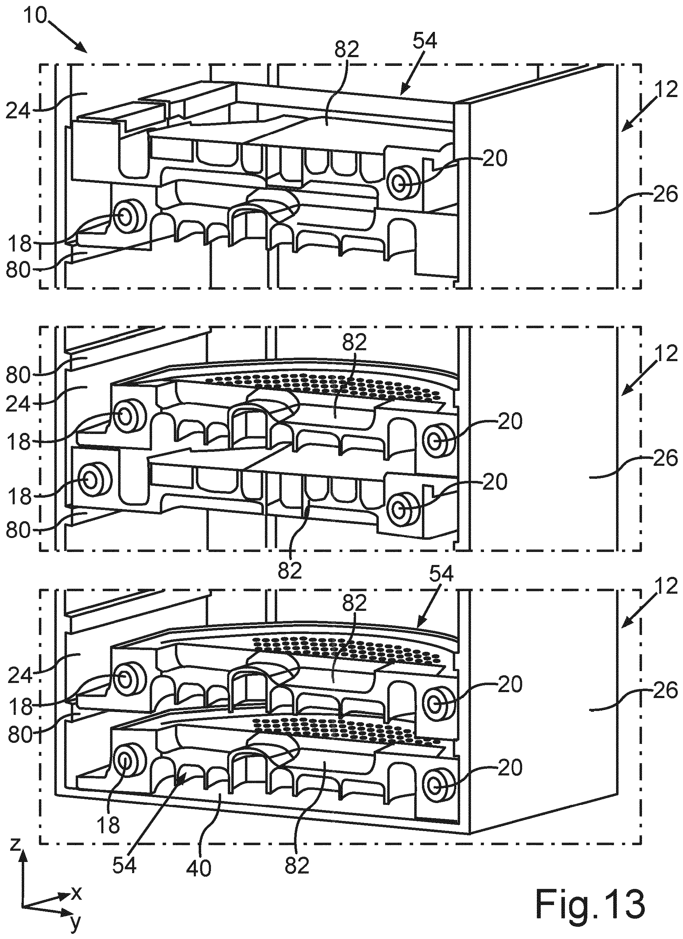

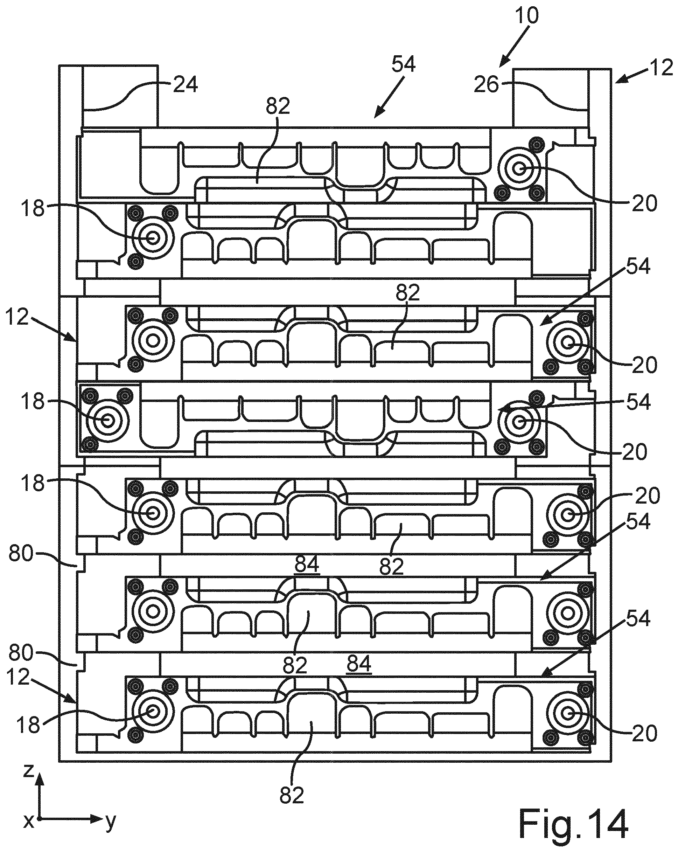

Further possibilities of arranging the circuit boards 14 in particular together with the at least one cooling device 16 in housings 12, which can be coupled to each other, are to be explained with reference to Fig. 13 and Fig. 14.

The circuit board arrangement 10 shown in Fig. 13 includes a first housing 12, which is an upper one in Fig. 13, a second housing 12, which is a middle one in Fig. 13, and a third housing 12, which is a lower one in Fig. 13. Herein the housings 12 are stacked on top of each other such that the respective sidewalls 24, 26 of adjacent housings 12 are oriented aligned with each other. In Fig. 13, the individual housings 12 are shown not yet connected to each other, while the housings 12 are fixed to each other in Fig. 14.

In this circuit board arrangement 10 too, guide elements in the form of guide bars 80 are arranged on the sidewalls 24, 26 opposing each other in transverse direction y, only some of which are provided with a reference character for reasons of clarity. Herein, it can be provided that an entire assembly 54 is movable or displaceable along the guide bars 80 into the depth direction x of the housing 12 to introduce the respective assembly 54 into the respective housing 12.

In the configuration of the assembly 54 shown at the top in Fig. 13, the cooling device 16 (not shown in more detail in Fig. 13) can be arranged between an upper circuit board 14 and a lower circuit board 14, wherein these circuit boards 14 either are not explicitly shown in Fig. 13. In Fig. 13, only an assembly housing 82 is shown, in which the common cooling device 16 and the two circuit boards 14 are arranged. Herein, the assembly housing 82 comprises the coolant inlet 18 and the coolant outlet 20. By this arrangement, efficient cooling of both circuit boards 14 can be effected by the centrally arranged cooling device 16. At the same time, the entire assembly 54 can be simply removed from the housing 12 and thus exchanged.

In the housing 12 arranged centrally in Fig. 13, two assembly housings 82 are arranged on top of each other. Herein, the two assembly housings 82 can lie on top of each other or abut on each other, wherein only the lower one of the two assembly housings 82 rests on the guide bars 80, which are formed on the sidewalls 24, 26 of the housing 12 opposing each other. Furthermore, the upper assembly housing 82 comprises an own coolant inlet 18 and an own coolant outlet 20, and also the lower assembly housing 82 comprises an own coolant inlet 18 and an own coolant outlet 20.

In this arrangement, the circuit boards 14 (not explicitly shown in Fig. 13) present in the respective assembly housing 82 can be arranged adjacent to each other or face each other. The two circuit boards 14 of the two assembly housings 82 lying on top of each other are then arranged between an upper cooling device 16 and a lower cooling device 16 in a sandwich-like construction, which either are not explicitly shown in Fig. 13. Herein, the upper cooling device 16 is associated with the upper assembly housing 82 and the lower cooling device 16 is associated with the lower assembly housing 82.

Accordingly, the two assembly housings 82 can be arranged mirror-imaged to each other with respect to a plane, which is parallel to a plane spanned by the depth direction x and the transverse direction y. However, it is also possible to arrange the two assembly housings 82 separate from each other such that the circuit boards 14 and the cooling devices 16 are arranged alternatingly in stacking direction. Herein too, the two assembly housings 82 can abut on each other.

In the arrangement of the assembly housings 82, shown at the bottom in Fig. 13, in the housing 12 of the circuit board arrangement 10, a respective clearance 84 (see Fig. 14) is formed between the respective assembly housings 82. Herein, a circuit board 14 (not shown) and a cooling device 16 (either not shown) are respectively arranged in each of the assembly housings 82. In the arrangement of the assemblies 54 above each other shown at the bottom in Fig. 13 too, each of the assembly housings 82 comprises an own coolant inlet 18 and an own coolant outlet 20.

The assembly 54, which is the lowest one in Fig. 13, can be pushed into the housing 12 along the bottom wall 40, while the assemblies 54 arranged above can be pushed into the housing 12 along the guide bars 80.

In Fig. 14, the assemblies 54 arranged in the respective housings 12 are shown in a front view of the circuit board arrangement 10, wherein the individual housings 12 are connected to each other. Herein, in the lower area of the circuit board arrangement 10, the individual assemblies 54 are arranged above each other while forming the clearances 84, while two individual assemblies 54 are arranged lying on top of each other in the housing 12 above. In contrast, in the housing 12, which is the uppermost in Fig. 14, an inverted arrangement is shown, in which the cooling device 16 (not shown) is arranged between the circuit boards 14 (either not shown) in vertical direction z.

The modular formation of the housings 12 shown in Fig. 13 and Fig. 14 allows a particularly flexible construction of the circuit board arrangement 10 and a simple exchange of the assemblies 54 and corresponding control devices or electronic control units of the circuit board arrangement 10, respectively.

## Claims

1. A circuit board arrangement (10) with at least one housing (12), in which a plurality of circuit boards (14) is arranged, and with at least one cooling device (16), through which a cooling fluid can be passed, and which is formed for dissipating heat from at least one of the circuit boards (14), wherein the at least one of the circuit boards (14) is thermally coupled to the at least one cooling device (16) by means of at least one heat transfer element (30),
**characterized in that**
the respective circuit board (14) is pivotable around a pivot axis (44) from a mounting position, in which the heat transfer element (30) abuts both on the at least one cooling device (16) and on the circuit board (14), into an intermediate position, wherein in the intermediate position, an edge area (50) of the circuit board (14) far from the pivot axis (44) is further spaced from the at least one cooling device (16) than in the mounting position, wherein the housing (12) comprises at least one guide element (38), and in introducing the circuit board (14) into the housing (12), the circuit board (14) is adapted to be displaced into the intermediate position along the at least one guide element (38).

2. The circuit board arrangement (10) according to claim 1,
**characterized in that**
the respective circuit board (14) is displaceable out of the housing (12) along the at least one guide element (38) starting from the intermediate position in removing the circuit board (14) from the housing (12).

3. The circuit board arrangement (10) according to any one of the preceding claims,
**characterized in that**
the heat transfer element (30) is formed as a heat conducting paste, which is spaced from the at least one cooling device (16) and abuts on the circuit board (14) in the intermediate position of the circuit board (14).

4. The circuit board arrangement (10) according to any one of the preceding claims, **characterized in that**
the respective circuit board (14) is arranged on a support plate (34), which is displaceable along the at least one guide element (38).

5. The circuit board arrangement (10) according to claim 4,
**characterized in that**
the support plate (34) comprises at least one locking element (46), which engages with a counterpart (48) provided on the side of the housing (12), in the mounting position of the circuit board (14).

6. The circuit board arrangement (10) according to claim 4 or 5,
**characterized in that**
the support plate (34) comprises at least one stud element (36), by which the pivot axis (44) is formed, wherein the at least one stud element (36) is received in a locking depression (42) provided on the side of the housing (12), in particular formed in an end area of the at least one guide element (38), both in the mounting position and in the intermediate position of the circuit board (14).

7. The circuit board arrangement (10) according to any one of the preceding claims, **characterized in that**
the circuit board arrangement (10), in particular the housing (12), comprises retaining means (56), which are formed for retaining the at least one cooling device (16) with the circuit board (14) pivoted into the intermediate position.

8. The circuit board arrangement (10) according to any one of the preceding claims, **characterized in that**
the at least one guide element is provided by respective guide rails (38) in particular oriented inclined related to a bottom wall (40) of the housing (12), which are formed on sidewalls (24, 26) of the housing (12) opposing each other.

9. The circuit board arrangement (10) according to any one of the preceding claims, **characterized in that**
circuit boards (14) arranged above each other in a vertical direction (z) of the housing (12) in the mounting position are connected to a further circuit board (58), which is arranged on a rear side of the housing (12), by means of a respective connecting element (60), wherein the rear side is opposing a front-side access opening (22) of the housing (12).

10. The circuit board arrangement (10) according to any one of the preceding claims, **characterized in that**
the circuit board arrangement (10) comprises a plurality of assemblies (54), in particular capable of being introduced into the housing (12) and/or removed from the housing (12) independently of each other, wherein a respective assembly (54) includes a cooling device (16) and at least one circuit board (14) coolable by means of this cooling device (16), wherein a clearance is formed between adjacent assemblies (54).

11. The circuit board arrangement (10) according to any one of the preceding claims, **characterized in that**
the at least one cooling device (16) includes a first side (28), which faces a first circuit board (14), and includes a second side (64), which faces a second circuit board (14), wherein the first circuit board (14) and the second circuit board (14) are thermally coupled to the same cooling device (16) by means of a respective heat transfer element (30).

12. The circuit board arrangement (10) according to any one of the preceding claims, **characterized in that**
respective structural elements (74), which comprise at least bearing areas (78) for the at least one cooling device (16), are arranged on sidewalls (24, 26) of the housing (12) opposing each other in transverse direction (y) of the housing (12), wherein bearing areas (78), which are lower ones in vertical direction (z) of the housing (12), have a smaller distance from each other in transverse direction (y) than bearing areas (78), which are upper ones in vertical direction (z) of the housing (12).

13. The circuit board arrangement (10) according to any one of the preceding claims, **characterized in that**
the circuit board arrangement (10) includes a plurality of housings (12) in particular fixed to each other, wherein sidewalls (24, 26) of adjacent housings (12) abut on each other and/or at least one sidewall (24, 26) of a first one of the housings (12) abuts on a bottom wall (40) and/or on a ceiling wall (72) of at least a second one of the housings (12).

14. The circuit board arrangement (10) according to any one of the preceding claims, **characterized in that**
the circuit board arrangement (10) includes a plurality of housings (12) in particular fixed to each other, wherein the housings (12) are stacked on top of each other, such that sidewalls (24, 26) of adjacent housings (12) are arranged aligned with each other.

15. The circuit board arrangement (10) according to any one of the preceding claims, **characterized in that**
in the housing (12), at least two circuit boards (14) arranged above each other are arranged between two cooling devices (16) in a sandwich-like construction and/or two cooling devices (16) arranged above each other are arranged between two circuit boards (14) in a sandwich-like construction.

## Patentansprüche

1. Leiterplattenanordnung (10) mit mindestens einem Gehäuse (12), in dem eine Vielzahl von Leiterplatten (14) angeordnet ist, und mit mindestens einer Kühlvorrichtung (16), durch die ein Kühlfluid geleitet werden kann und die zur Ableitung von Wärme von mindestens einer der Leiterplatten (14) ausgebildet ist, wobei die mindestens eine der Leiterplatten (14) mittels mindestens eines Wärmeübertragungselements (30) thermisch mit der mindestens einen Kühlvorrichtung (16) gekoppelt ist, **dadurch gekennzeichnet, dass** die jeweilige Leiterplatte (14) um eine Schwenkachse (44) aus einer Montageposition, in der das Wärmeübertragungselement (30) sowohl an der mindestens einen Kühlvorrichtung (16) als auch an der Leiterplatte (14) anliegt, in eine Zwischenposition schwenkbar ist, wobei in der Zwischenposition ein von der Schwenkachse (44) entfernter Randbereich (50) der Leiterplatte (14) weiter von der mindestens einen Kühlvorrichtung (16) beabstandet ist als in der Montageposition, wobei das Gehäuse (12) mindestens ein Führungselement (38) umfasst, und die Leiterplatte (14) beim Einführen der Leiterplatte (14) in das Gehäuse (12) entlang des mindestens einen Führungselements (38) in die Zwischenposition verschiebbar ist.

2. Leiterplattenanordnung (10) nach Anspruch 1, **dadurch gekennzeichnet, dass** die jeweilige Leiterplatte (14) beim Entfernen der Leiterplatte (14) aus dem Gehäuse (12) ausgehend von der Zwischenposition entlang des mindestens einen Führungselements (38) aus dem Gehäuse (12) heraus verschiebbar ist.

3. Leiterplattenanordnung (10) nach einem der vorhergehenden Ansprüche, **dadurch gekennzeichnet, dass** das Wärmeübertragungselement (30) als Wärmeleitpaste ausgebildet ist, die in der Zwischenposition der Leiterplatte (14) von der mindestens einen Kühlvorrichtung (16) beabstandet ist und an der Leiterplatte (14) anliegt.

4. Leiterplattenanordnung (10) nach einem der vorhergehenden Ansprüche, **dadurch gekennzeichnet, dass** die jeweilige Leiterplatte (14) auf einer Trägerplatte (34) angeordnet ist, die entlang des mindestens einen Führungselements (38) verschiebbar ist.

5. Leiterplattenanordnung (10) nach Anspruch 4, **dadurch gekennzeichnet, dass** die Trägerplatte (34) mindestens ein Verriegelungselement (46) umfasst, das in der Montageposition der Leiterplatte (14) mit einem gehäuseseitig vorgesehenen Gegenstück (48) in Eingriff steht.

6. Leiterplattenanordnung (10) nach Anspruch 4 oder 5, **dadurch gekennzeichnet, dass** die Trägerplatte (34) mindestens ein Zapfenelement (36) umfasst, durch das die Schwenkachse (44) gebildet ist, wobei das mindestens eine Zapfenelement (36) sowohl in der Montageposition als auch in der Zwischenposition der Leiterplatte (14) in einer gehäuseseitig vorgesehenen Verriegelungsvertiefung (42) aufgenommen ist, die insbesondere in einem Endbereich des mindestens einen Führungselements (38) ausgebildet ist.

7. Leiterplattenanordnung (10) nach einem der vorhergehenden Ansprüche, **dadurch gekennzeichnet, dass** die Leiterplattenanordnung (10), insbesondere das Gehäuse (12), Haltemittel (56) umfasst, die zum Halten der mindestens einen Kühlvorrichtung (16) bei in die Zwischenposition geschwenkter Leiterplatte (14) ausgebildet sind.

8. Leiterplattenanordnung (10) nach einem der vorhergehenden Ansprüche, **dadurch gekennzeichnet, dass** das mindestens eine Führungselement durch jeweilige Führungsschienen (38) bereitgestellt ist, die insbesondere bezogen auf eine Bodenwand (40) des Gehäuses (12) geneigt ausgerichtet sind und an einander gegenüberliegenden Seitenwänden (24, 26) des Gehäuses (12) ausgebildet sind.

9. Leiterplattenanordnung (10) nach einem der vorhergehenden Ansprüche, **dadurch gekennzeichnet, dass** in einer Vertikalrichtung (z) des Gehäuses (12) in der Montageposition übereinander angeordnete Leiterplatten (14) mittels eines jeweiligen Verbindungselements (60) mit einer weiteren Leiterplatte (58) verbunden sind, die an einer Rückseite des Gehäuses (12) angeordnet ist, wobei die Rückseite einer frontseitigen Zugangsöffnung (22) des Gehäuses (12) gegenüberliegt.

10. Leiterplattenanordnung (10) nach einem der vorhergehenden Ansprüche, **dadurch gekennzeichnet, dass** die Leiterplattenanordnung (10) eine Vielzahl von Baugruppen (54) umfasst, die insbesondere unabhängig voneinander in das Gehäuse (12) einführbar und/oder aus dem Gehäuse (12) entfernbar sind, wobei eine jeweilige Baugruppe (54) eine Kühlvorrichtung (16) und mindestens eine mittels dieser Kühlvorrichtung (16) kühlbare Leiterplatte (14) umfasst, wobei zwischen benachbarten Baugruppen (54) ein Freiraum ausgebildet ist.

11. Leiterplattenanordnung (10) nach einem der vorhergehenden Ansprüche, **dadurch gekennzeichnet, dass** die mindestens eine Kühlvorrichtung (16) eine erste Seite (28) umfasst, die einer ersten Leiterplatte (14) zugewandt ist, und eine zweite Seite (64) umfasst, die einer zweiten Leiterplatte (14) zugewandt ist, wobei die erste Leiterplatte (14) und die zweite Leiterplatte (14) mittels eines jeweiligen Wärmeübertragungselements (30) thermisch mit derselben Kühlvorrichtung (16) gekoppelt sind.

12. Leiterplattenanordnung (10) nach einem der vorhergehenden Ansprüche, **dadurch gekennzeichnet, dass** an einander in Querrichtung (y) des Gehäuses (12) gegenüberliegenden Seitenwänden (24, 26) des Gehäuses (12) jeweilige Strukturelemente (74) angeordnet sind, wobei die jeweiligen Strukturelemente (74) mindestens Auflageflächen (78) für die mindestens eine Kühlvorrichtung (16) umfassen, wobei in Vertikalrichtung (z) des Gehäuses (12) untere Auflageflächen (78) einen kleineren Abstand voneinander in Querrichtung (y) aufweisen als in Vertikalrichtung (z) des Gehäuses (12) obere Auflageflächen (78).

13. Leiterplattenanordnung (10) nach einem der vorhergehenden Ansprüche, **dadurch gekennzeichnet, dass** die Leiterplattenanordnung (10) eine Vielzahl von insbesondere miteinander befestigten Gehäusen (12) umfasst, wobei Seitenwände (24, 26) benachbarter Gehäuse (12) aneinander anliegen und/oder mindestens eine Seitenwand (24, 26) eines ersten der Gehäuse (12) an einer Bodenwand (40) und/oder an einer Deckenwand (72) mindestens eines zweiten der Gehäuse (12) anliegt.

14. Leiterplattenanordnung (10) nach einem der vorhergehenden Ansprüche, **dadurch gekennzeichnet, dass** die Leiterplattenanordnung (10) eine Vielzahl von insbesondere miteinander befestigten Gehäusen (12) umfasst, wobei die Gehäuse (12) so übereinander gestapelt sind, dass Seitenwände (24, 26) benachbarter Gehäuse (12) fluchtend zueinander angeordnet sind.

15. Leiterplattenanordnung (10) nach einem der vorhergehenden Ansprüche, **dadurch gekennzeichnet, dass** im Gehäuse (12) mindestens zwei übereinander angeordnete Leiterplatten (14) in einer sandwichartigen Konstruktion zwischen zwei Kühlvorrichtungen (16) angeordnet sind und/oder zwei übereinander angeordnete Kühlvorrichtungen (16) in einer sandwichartigen Konstruktion zwischen zwei Leiterplatten (14) angeordnet sind.

## Revendications

1. Disposition de carte de circuit imprimé (10) avec au moins un boîtier (12), dans lequel une pluralité de cartes de circuit imprimé (14) est disposée, et avec au moins un dispositif de refroidissement (16), à travers lequel un fluide de refroidissement peut circuler, et qui est formé pour dissiper la chaleur d'au moins une des cartes de circuit imprimé (14), où l'au moins une des cartes de circuit imprimé (14) est thermiquement couplée à l'au moins un dispositif de refroidissement (16) au moyen d'au moins un élément de transfert de chaleur (30), **caractérisée en ce que** la carte de circuit imprimé respective (14) est pivotable autour d'un axe de pivot (44) d'une position de montage, dans laquelle l'élément de transfert de chaleur (30) s'appuie à la fois sur l'au moins un dispositif de refroidissement (16) et sur la carte de circuit imprimé (14), à une position intermédiaire, où dans la position intermédiaire, une zone de bord (50) de la carte de circuit imprimé (14) éloignée de l'axe de pivot (44) est davantage espacée de l'au moins un dispositif de refroidissement (16) que dans la position de montage, où le boîtier (12) comprend au moins un élément de guidage (38), et lors de l'introduction de la carte de circuit imprimé (14) dans le boîtier (12), la carte de circuit imprimé (14) est adaptée pour être déplacée dans la position intermédiaire le long de l'au moins un élément de guidage (38).

2. Disposition de carte de circuit imprimé (10) selon la revendication 1, **caractérisée en ce que** la carte de circuit imprimé respective (14) est déplaçable hors du boîtier (12) le long de l'au moins un élément de guidage (38) à partir de la position intermédiaire lors du retrait de la carte de circuit imprimé (14) du boîtier (12).

3. Disposition de carte de circuit imprimé (10) selon l'une quelconque des revendications précédentes, **caractérisée en ce que** l'élément de transfert de chaleur (30) est formé comme une pâte conductrice de chaleur, qui est espacée de l'au moins un dispositif de refroidissement (16) et s'appuie sur la carte de circuit imprimé (14) dans la position intermédiaire de la carte de circuit imprimé (14).

4. Disposition de carte de circuit imprimé (10) selon l'une quelconque des revendications précédentes, **caractérisée en ce que** la carte de circuit imprimé respective (14) est disposée sur une plaque de support (34), qui est déplaçable le long de l'au moins un élément de guidage (38).

5. Disposition de carte de circuit imprimé (10) selon la revendication 4, **caractérisée en ce que** la plaque de support (34) comprend au moins un élément de verrouillage (46), qui s'engage avec une contrepartie (48) prévue du côté du boîtier (12), dans la position de montage de la carte de circuit imprimé (14).

6. Disposition de carte de circuit imprimé (10) selon la revendication 4 ou 5, **caractérisée en ce que** la plaque de support (34) comprend au moins un élément de goujon (36), par lequel l'axe de pivot (44) est formé, où l'au moins un élément de goujon (36) est reçu dans une dépression de verrouillage (42) prévue du côté du boîtier (12), en particulier formée dans une zone d'extrémité de l'au moins un élément de guidage (38), à la fois dans la position de montage et dans la position intermédiaire de la carte de circuit imprimé (14).

7. Disposition de carte de circuit imprimé (10) selon l'une quelconque des revendications précédentes, **caractérisée en ce que** la disposition de carte de circuit imprimé (10), en particulier le boîtier (12), comprend des moyens de retenue (56), qui sont formés pour retenir l'au moins un dispositif de refroidissement (16) avec la carte de circuit imprimé (14) pivotée dans la position intermédiaire.

8. Disposition de carte de circuit imprimé (10) selon l'une quelconque des revendications précédentes, **caractérisée en ce que** l'au moins un élément de guidage est fourni par des rails de guidage respectifs (38) en particulier orientés inclinés par rapport à une paroi de fond (40) du boîtier (12), qui sont formés sur des parois latérales (24, 26) du boîtier (12) s'opposant l'une à l'autre.

9. Disposition de carte de circuit imprimé (10) selon l'une quelconque des revendications précédentes, **caractérisée en ce que** des cartes de circuit imprimé (14) disposées les unes au-dessus des autres dans une direction verticale (z) du boîtier (12) dans la position de montage sont connectées à une autre carte de circuit imprimé (58), qui est disposée sur un côté arrière du boîtier (12), au moyen d'un élément de connexion respectif (60), où le côté arrière est opposé à une ouverture d'accès côté avant (22) du boîtier (12).

10. Disposition de carte de circuit imprimé (10) selon l'une quelconque des revendications précédentes, **caractérisée en ce que** la disposition de carte de circuit imprimé (10) comprend une pluralité d'assemblages (54), en particulier capables d'être introduits dans le boîtier (12) et/ou retirés du boîtier (12) indépendamment les uns des autres, où un assemblage respectif (54) comprend un dispositif de refroidissement (16) et au moins une carte de circuit imprimé (14) refroidissable au moyen de ce dispositif de refroidissement (16), où un espace libre est formé entre des assemblages adjacents (54).

11. Disposition de carte de circuit imprimé (10) selon l'une quelconque des revendications précédentes, **caractérisée en ce que** l'au moins un dispositif de refroidissement (16) comprend un premier côté (28), qui fait face à une première carte de circuit imprimé (14), et comprend un second côté (64), qui fait face à une seconde carte de circuit imprimé (14), où la première carte de circuit imprimé (14) et la seconde carte de circuit imprimé (14) sont thermiquement couplées au même dispositif de refroidissement (16) au moyen d'un élément de transfert de chaleur respectif (30).

12. Disposition de carte de circuit imprimé (10) selon l'une quelconque des revendications précédentes, **caractérisée en ce que** des éléments structurels respectifs (74), qui comprennent au moins des zones d'appui (78) pour l'au moins un dispositif de refroidissement (16), sont disposés sur des parois latérales (24, 26) du boîtier (12) s'opposant l'une à l'autre dans la direction transversale (y) du boîtier (12), où des zones d'appui (78), qui sont inférieures dans la direction verticale (z) du boîtier (12), ont une distance plus petite l'une de l'autre dans la direction transversale (y) que des zones d'appui (78), qui sont supérieures dans la direction verticale (z) du boîtier (12).

13. Disposition de carte de circuit imprimé (10) selon l'une quelconque des revendications précédentes, **caractérisée en ce que** la disposition de carte de circuit imprimé (10) comprend une pluralité de boîtiers (12) en particulier fixés les uns aux autres, où des parois latérales (24, 26) de boîtiers adjacents (12) s'appuient les unes sur les autres et/ou au moins une paroi latérale (24, 26) d'un premier des boîtiers (12) s'appuie sur une paroi de fond (40) et/ou sur une paroi de plafond (72) d'au moins un second des boîtiers (12).

14. Disposition de carte de circuit imprimé (10) selon l'une quelconque des revendications précédentes, **caractérisée en ce que** la disposition de carte de circuit imprimé (10) comprend une pluralité de boîtiers (12) en particulier fixés les uns aux autres, où les boîtiers (12) sont empilés les uns sur les autres, de sorte que des parois latérales (24, 26) de boîtiers adjacents (12) soient disposées alignées les unes avec les autres.

15. Disposition de carte de circuit imprimé (10) selon l'une quelconque des revendications précédentes, **caractérisée en ce que** dans le boîtier (12), au moins deux cartes de circuit imprimé (14) disposées l'une au-dessus de l'autre sont disposées entre deux dispositifs de refroidissement (16) dans une construction en sandwich et/ou deux dispositifs de refroidissement (16) disposés l'un au-dessus de l'autre sont disposés entre deux cartes de circuit imprimé (14) dans une construction en sandwich.
